# EUROPEAN PATENT APPLICATION

(11) **EP 4 236 635 A1**
(43) Date of publication of application: **30.08.2023**
(21) Application number: 21883255.8
(22) Date of filing: 20.10.2021
(51) Int. Cl.: H05K 1/02, H05K 3/34

(54) **POWER AMPLIFICATION DEVICE AND MANUFACTURING METHOD THEREOF**

(30) Priority: 21.10.2020 KR 20200136528
(71) Applicant: KMW Inc., Hwaseong-si, Gyeonggi-do 18462 (KR)
(72) Inventor: JEONG, Bae Mook, Suwon-si Gyeonggi-do 16545 (KR); AHN, Seong Min, Namyangju-si Gyeonggi-do 12109 (KR); KIM, Jae Eun, Suwon-si Gyeonggi-do 16330 (KR); LEE, Seung Min, Suwon-si Gyeonggi-do 16461 (KR); YEO, Jin Soo, Hwaseong-si Gyeonggi-do 18488 (KR)
(74) Representative: SJW Patentanwälte
(86) International application number: PCT/KR2021/014750
(87) International publication number: WO 2022/086187

(57) **Abstract**

Provided are a power amplification device and a manufacturing method thereof, wherein the power amplification device provides compact substrates by laminating a plurality of substrates, and has improved heat dissipating performance since a heat dissipating plate is installed to be in surface-contact with one of the plurality of substrates, and a heating element mounted on the substrate is in contact with the heat dissipating plate.

To this end, the power amplification device, according to the present disclosure, comprises: a first board having a first through-hole penetrating from the front to rear thereof; a second board of which the front surface is disposed on the rear surface of the first board, has a second through-hole penetrating from the front to rear thereof at a position corresponding to the first through-hole, and has a heating element penetrating the first through-hole and the second through-hole; and a heat dissipating plate of which the front surface is disposed on the rear surface of the second board and is in contact with the rear surface of the heating element.

## Description

### [Technical Field]

The present disclosure relates to a power amplification device and a method of manufacturing the same, and more specifically, to a power amplification device and a method of manufacturing the same capable of efficiently dissipating heat generated from a heat element mounted on a printed circuit board (PCB).

### [Background Art]

Generally, communication devices including an antenna are provided with a power amplifier (PA) for amplifying communication signals therein, and the PA has an amplification element formed to be mounted on a circuit printed on a front surface of a substrate.

Since the amplification element is a heating element for generating heat during operation, the communication device including the amplification element needs to quickly dissipate heat generated from the amplification element to the outside.

To this end, the conventional power amplification device adopts a structure in which after the amplification element is mounted on the front surface of the substrate, a plurality of via holes are processed to pass through a portion of the substrate on which the amplification element is mounted in a front-rear direction or a plurality of coin insertion grooves are processed at positions of a surface of the substrate, which corresponds to the plurality of via holes, and a heat transmission coin is installed to be inserted into each of the plurality of coin insertion grooves, thereby dissipating heat.

However, the conventional power amplification device has a problem that since the substrate is made of a synthetic resin material having low thermal conductivity, the structure that dissipates heat through the via hole has poor heat dissipation performance due to a small contact area between the amplification element and the via hole, and the structure in which the plurality of heat transmission coins are installed on the substrate has also a problem that the heat dissipation effect is reduced by a contact tolerance of a contact surface with the amplification element, and since the plurality of coin insertion grooves need to be processed in the rear surface of the substrate to install the plurality of heat transmission coins therein, the number of operating processes and costs are increased.

### [Disclosure]

### [Technical Problem]

The present disclosure is directed to providing a power amplification device and a method of manufacturing the same, which provide compact substrates by laminating a plurality of substrates, install a heat dissipating plate to be in surface contact with one of the plurality of substrates, and bring a heating element mounted on the substrate into contact with the heat dissipating plate, thereby improving heat dissipation performance.

Objects of the present disclosure are not limited to the above-described objects, and other objects that are not mentioned will be able to be clearly understood by those skilled in the art from the following description.

### [Technical Solution]

In order to achieve the objects, a power amplification device according to the present disclosure is composed of a first board, a second board, and a heat dissipating plate. The first board is formed with a first through-hole passing through the first board in a front-rear direction. A front surface of a second board is disposed on a rear surface of the first board. The second board is formed with a second through-hole passing through the second board in the front-rear direction at a position corresponding to the first through-hole. The second board is equipped with a heating element passing through the first through-hole and the second through-hole. A front surface of a heat dissipating plate is disposed on a rear surface of the second board. A rear surface of the heating element is in contact with the front surface of the heat dissipating plate.

An edge of each of the first board, the second board, and the heat dissipating plate may be formed to have the same size.

A terminal of the heating element may be soldered to a terminal mounting part of a circuit printed to the front surface of the second board.

A thickness of the second board in the front-rear direction may be formed to be smaller than the thickness of the first board in the front-rear direction.

A thickness of the first board and the second board in contact with each other in the front-rear direction may be formed to be smaller than a thickness of the heating element in the front-rear direction.

A thickness of the first board and the second board in contact with each other in the front-rear direction may be formed to be the same as a thickness of the heating element in the front-rear direction.

Each of the first board and the second board may be formed of a plurality of layers. The second board may be formed of fewer layers than the first board.

The first board may be made of a synthetic resin material. The second board may be made of a metal material.

A vertical length of the first through-hole may be formed to be half or more of a vertical length of the first board. The second through-hole may be formed to have a smaller size than the first through-hole.

The front surface of the heat dissipating plate may be formed with an insertion groove into which a rear end of the heating element is inserted.

The first board may include a plurality of sections divided by plated portions, which form a circuit printed on the front surface of the first board, in a left-right direction. The first through-hole may be formed one by one in the plurality of sections and formed of a plurality of first through-holes. The second through-hole may be formed at a position corresponding to each of the plurality of first through-holes and formed of a plurality of second through-holes. The insertion groove may be formed at a position corresponding to each of the plurality of second through-holes and formed of a plurality of insertion grooves. The heating element may pass through each of the plurality of first through-holes and each of the plurality of second through-holes and formed of a plurality of heating elements, each of which has a rear end inserted into each of the plurality of insertion grooves.

The heating element may be formed as an RF element.

The heating element may be formed as a transmission amplification element.

The first board may be equipped with a power element and a control element.

The first board may be formed with a circuit connection part. A circuit connection part may extend from the front surface of the first board to the rear surface of the first board and may be electrically connected to a circuit printed on the front surface of the second board. The circuit connection part may be formed with a connector pin connection hole extending in the front-rear direction. The connector pin connection hole may have a connector pin formed on a rear surface of a filter inserted therein and may be electrically connected to the circuit connection part.

The first board may be formed with an opening hole extending in the front-rear direction. The circuit connection part may be provided on a side surface of the opening hole. The connector pin connection hole may have an open portion opposite to the side surface of the opening hole.

A method of manufacturing a power amplification device according to the present disclosure includes step (a), step (b), step (c), step (d), and step (e). In step (a), a solder cream is applied to a front surface of a first board formed with a first through-hole extending in a front-rear direction, then a rear surface of a first element is reflowed to the front surface of the first board, and the solder cream is applied to the rear surface of the first board. In step (b), the solder cream is applied to a front surface of a second board formed with a second through-hole extending in the front-rear direction at a position corresponding to the first through-hole, and then a rear surface of a second element is reflowed to the front surface of the second. In step (c), the solder cream is applied to a front surface of a heat dissipating plate. In step (d), a rear surface of the second board is arranged on the front surface of the heat dissipating plate, the rear surface of the first board is arranged on the front surface of the second board, and then the solder cream is applied to a terminal mounting part of a circuit printed on the front surface of the second board. In step (e), the heating element passes through the first through-hole and the second through-hole to bring a rear surface of the heating element into contact with the front surface of the heat dissipating plate, a terminal of the heating element is in contact with the terminal mounting part, and then the rear surface of the first board and the front surface of the second board, the rear surface of the second board and the front surface of the heat dissipating plate, and the terminal of the heating element and the terminal mounting part are reflowed at the same time.

In step (d), the front surface of the heat dissipating plate may be formed with an insertion groove through the first through-hole and the second through-hole, and in step (e), a rear end of the heating element may be inserted into the insertion groove.

In step (e), a rear end of the heating element may be inserted into an insertion groove formed in the front surface of the heat dissipating plate.

The first board may include a plurality of sections divided by plated portions, which form a circuit printed on the front surface of the first board, in a left-right direction. The first through-hole may be formed one by one in the plurality of sections and formed of a plurality of first through-holes. The second through-hole may be formed at a position corresponding to each of the plurality of first through-holes and formed of a plurality of second through-holes. The insertion groove may be formed at a position corresponding to each of the plurality of second through-holes and formed of a plurality of insertion grooves. The heating element may pass through each of the plurality of first through-holes and each of the plurality of second through-holes and formed of a plurality of heating elements, each of which has a rear end inserted into each of the plurality of insertion grooves.

A method of manufacturing a power amplification device according to the present disclosure includes step (a), step (b), step (c), step (d), and step (e). In step (a), a solder cream is applied to a front surface of a first board formed with a first through-hole extending in a front-rear direction, then a rear surface of a first element is mounted to the front surface of the first board, and the solder cream is applied to the rear surface of the first board. In step (b), the solder cream is applied to a front surface of a second board formed with a second through-hole extending in the front-rear direction at a position corresponding to the first through-hole, and then a rear surface of a second element is reflowed to the front surface of the second board. In step (c), the solder cream is applied to a front surface of a heat dissipating plate. In step (d), a rear surface of the second board is arranged on the front surface of the heat dissipating plate, the rear surface of the first board is arranged on the front surface of the second board, and then the solder cream is applied to a terminal mounting part of a circuit printed on the front surface of the second board. In step (e), the heating element passes through the first through-hole and the second through-hole to bring a rear surface of the heating element into contact with the front surface of the heat dissipating plate, a terminal of the heating element is in contact with the terminal mounting part, and then the rear surface of the first element and the front surface of the first board, the rear surface of the second element and the front surface of the second board, the rear surface of the first board and the front surface of the second board, the rear surface of the second board and the front surface of the heat dissipating plate, and the terminal of the heating element and the terminal mounting part are reflowed at the same time.

In step (d), the front surface of the heat dissipating plate may be formed with an insertion groove through the first through-hole and the second through-hole, and in step (e), a rear end of the heating element may be inserted into the insertion groove.

In step (e), a rear end of the heating element may be inserted into an insertion groove formed in the front surface of the heat dissipating plate.

The first board may include a plurality of sections divided by plated portions, which form a circuit printed on the front surface of the first board, in a left-right direction. The first through-hole may be formed one by one in the plurality of sections and formed of a plurality of first through-holes. The second through-hole may be formed at a position corresponding to each of the plurality of first through-holes and formed of a plurality of second through-holes. The insertion groove may be formed at a position corresponding to each of the plurality of second through-holes and formed of a plurality of insertion grooves. The heating element may pass through each of the plurality of first through-holes and each of the plurality of second through-holes and formed of a plurality of heating elements, each of which has a rear end inserted into each of the plurality of insertion grooves.

Detailed matters of other embodiments are included in a detailed description and accompanying drawings.

### [Advantageous Effects]

According to the power amplification device and the method of manufacturing the same according to the present disclosure, the first board and the second board can be installed to be in surface contact with each other, thereby compactly forming the first board and the second board compact, and since the heat dissipating plate can be installed to be in surface contact with the second board and the heating element mounted on the second board can be in contact with the heat dissipating plate, the heat generated from the heating element can be dissipated through the heat dissipating plate, thereby improving heat dissipation performance.

Effects of the present disclosure are not limited to the above-described effects, and other effects that are not mentioned will be able to be clearly understood by those skilled in the art from the following description.

### [Description of Drawings]

FIG. 1 is a perspective view showing a power amplification device according to an embodiment of the present disclosure.
FIG. 2 is a right side view of the power amplification device shown in FIG. 1.
FIG. 3 is a front view of the power amplification device shown in FIG. 1.
FIG. 4 is an exploded perspective view of the power amplification device shown in FIG. 1.
FIG. 5 is an exploded perspective view of a second board shown in FIG. 4.
FIG. 6 is a cross-sectional view along line A-A in FIG. 3.
FIG. 7 is a perspective view of a heating element shown in FIG. 5.
FIG. 8 is a perspective view of a bottom surface of the heating element in FIG. 7.
FIG. 9 is an enlarged view of portion A in FIG. 1.
FIG. 10 is a view showing one embodiment of a process of manufacturing the power amplification device shown in FIG. 1.
FIG. 11 is a view showing another embodiment of the process of manufacturing the power amplification device shown in FIG. 1.
FIG. 12 is a view showing still another embodiment of the process of manufacturing the power amplification device shown in FIG. 1.

### <Description of reference numerals>

300: Power amplification device 310: First board
316: Circuit connection unit 317: Connector pin connection hole
319: First element 320: Second board
321: Second through-hole 322: Heating element
322A, 322B: Terminals of heating element 328: Terminal mounting portion
329: Second element 330: Heat dissipating plate
331: Insertion groove

### [Mode for Invention]

Hereinafter, a power amplification device and a method of manufacturing the same according to an embodiment of the present disclosure will be described with reference to the accompanying drawings.

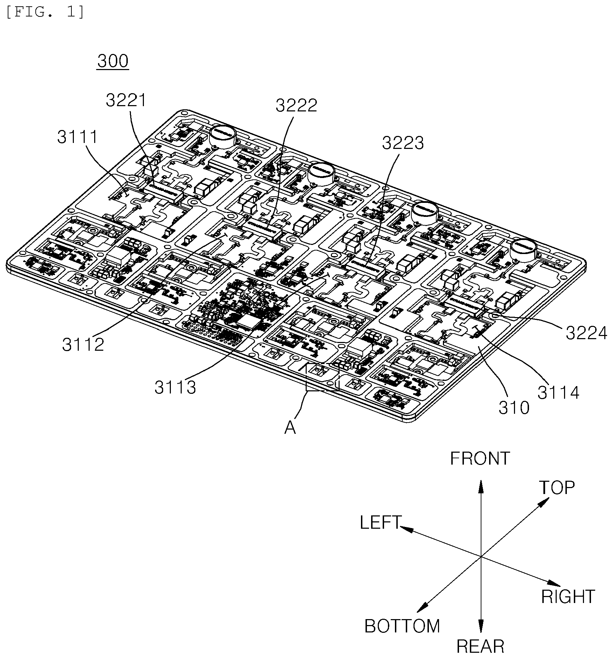

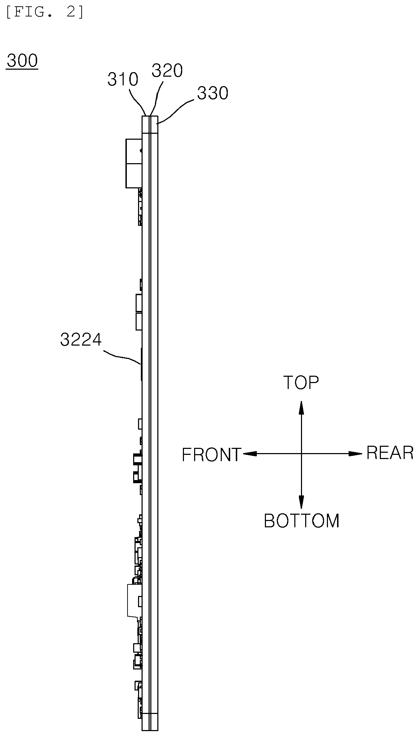

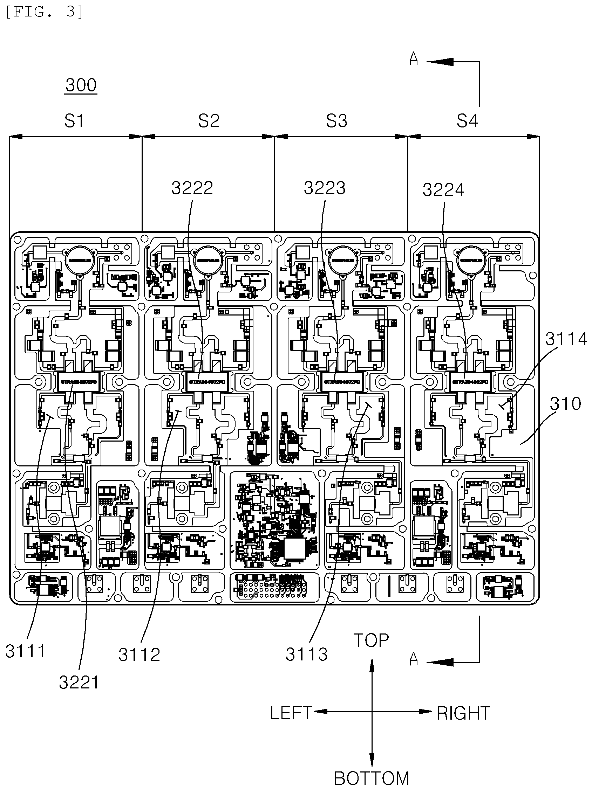

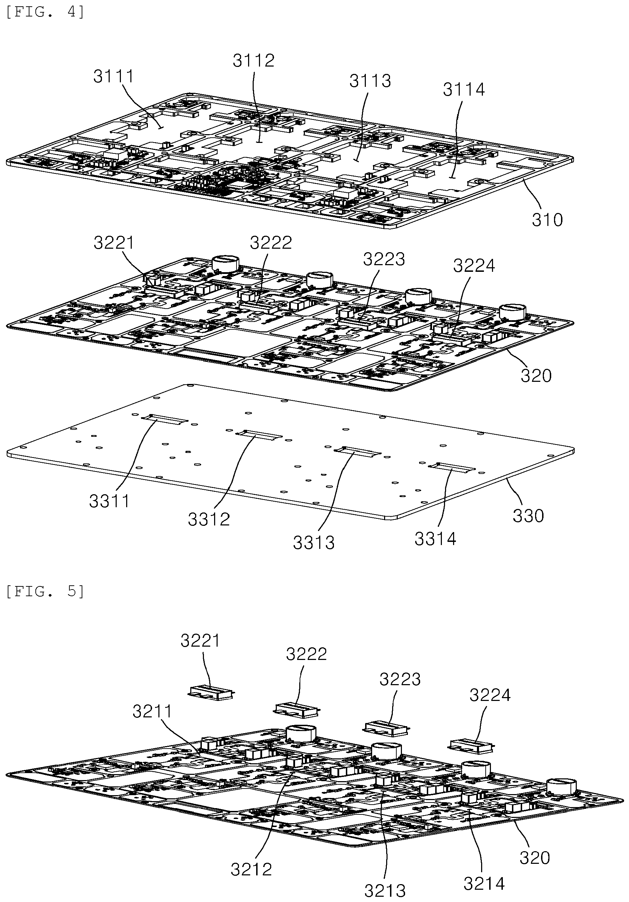

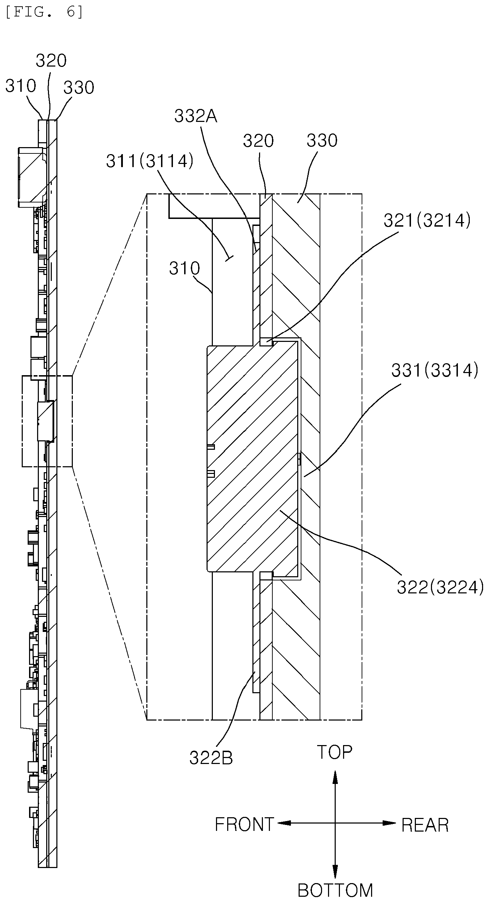

FIG. 1 is a perspective view showing a power amplification device according to an embodiment of the present disclosure, FIG. 2 is a right side view of the power amplification device shown in FIG. 1, FIG. 3 is a front view of the power amplification device shown in FIG. 1, FIG. 4 is an exploded perspective view of the power amplification device shown in FIG. 1, FIG. 5 is an exploded perspective view of a second board shown in FIG. 4, and FIG. 6 is a cross-sectional view along line A-A in FIG. 3.

Referring to FIGS. 1 to 6, in the following description, forward, backward, upward, downward, leftward, and rightward directions are based on forward, backward, upward, downward, leftward, and rightward directions shown in FIG. 1, and the directions may also be set differently depending on a structure of a communication device provided with a power amplification device 300 according to the embodiment of the present disclosure.

A radio frequency (RF) element may be mounted on the power amplification device 300. The RF element may be an amplification element and may include a transmission amplification element (Tx or power amplifier (PA)) and a reception amplification element (Rx or low noise amplifier (LNA)). The power amplification device 300 may transmit an RF signal amplified by the transmission amplification element Tx to the outside through a filter and an antenna element provided in the communication device.

The power amplification device 300 according to the embodiment of the present disclosure may include a first board 310, a second board 320, and a heat dissipating plate 330. Here, the first board 310 may be disposed in front of the second board 320, and the second board 320 may be disposed in front of the heat dissipating plate 330.

The first board 310 may be a power and control board, and the second board 320 may be an RF board. The first board 310 may be equipped with a power element and a control element for generating a signal having no frequency, for example, a power signal or a control signal, and the second board 320 may be equipped with the RF element for generating the RF signal having a frequency.

Each edge of the first board 310, the second board 320, and the heat dissipating plate 330 may be formed in the same shape. In the embodiment, the edge shape of each of the first board 310, the second board 320, and the heat dissipating plate 330 is formed in a rectangular shape. A size of each edge of the first board 310, the second board 320, and the heat dissipating plate 330 may be identically formed.

A thickness of the second board 320 in a front-rear direction may be smaller than a thickness of the first board 310 in the front-rear direction. In the embodiment, the thickness of the first board 310 in the front-rear direction is formed to be 1.7 mm, and the thickness of the second board 320 in the front-rear direction is formed to be 0.65 mm. Since the thickness of the second board 320 is smaller than that of the first board 310, heat generated from the elements mounted on each of the first board 310 and the second board 320 may be easily transmitted to the heat dissipating plate 330.

Here, the heat dissipating plate 330 may be a plate-shaped pallet used to improve the productivity of a PCB and reduce defective PCBs while a reflow process is performed. In addition, the heat dissipating plate 330 may be made of a heat-resistant material to sufficiently withstand the high heat of the reflow process and may be made of a material having little thermal deformation, such as a composite material in which glass fibers are added to a heat-resistant resin or made of a metal material having high thermal conductivity, such as an aluminum/aluminum alloy plate, a copper plate, or a magnesium plate, so as to be advantageous in heat transmission to the outside of the communication device provided with the power amplification device 300.

Each of the first board 310 and the second board 320 may be formed of a plurality of layers. The second board 320 may be formed of fewer layers than the first board 310. The conventional boards are formed of 6 layers, but in the embodiment, in order to maintain a thickness equivalent to that of the conventional board, the first board 310 is formed of 4 layers, and the second board 320 is formed of 2 layers.

The first board 310 may be made of a synthetic resin material. For example, the first board 310 may be made of an FR4 resin material of an epoxy resin material. The second board 320 may be made of a metal material. Since the second board 320 is made of the metal material, the heat generated from the elements mounted on the first board 310 and the second board 320 may be easily transmitted to the heat dissipating plate 330.

The first board 310 may include a plurality of sections S1, S2, S3, and S4 (see FIG. 3) divided at equal intervals in a left-right direction. The plurality of sections S1, S2, S3, and S4 may be divided by plated portions, which form a circuit printed on the front surface of the first board 310.

In the embodiment, four sections S1, S2, S3, and S4 are formed, but the number of the plurality of sections S1, S2, S3, and S4 is not limited to four, and at least two or more sections may be formed. The following description will be limited to a case in which the four sections S1, S2, S3, and S4 are formed.

The plurality of sections S1, S2, S3, and S4 may include the first section S1, the second section S2, the third section S3, and the fourth section S4.

The first section S1 may be disposed at a leftmost side of the first board 310. The first section S1 may be disposed at a left side of the second section S2 in the first board 310.

The second section S2 may be disposed at a right side of the first section S1 in the first board 310. The second section S2 may be disposed at a left side of the third section S3 in the first board 310. The second section S2 may be disposed between the first section S1 and the third section S3 in the first board 310.

The third section S3 may be disposed at a right side of the second section S2 in the first board 310. The third section S3 may be disposed at a left side of the fourth section S4 in the first board 310. The third section S3 may be disposed between the second section S2 and the fourth section S4 in the first board 310.

The fourth section S4 may be disposed at a right side of the third section S3 in the first board 310. The fourth section S4 may be disposed at a rightmost side of the first board 310.

A first through-hole 311 (see FIG. 6) may be formed in the first board 310 to pass through the first board 310 in the front-rear direction. The first through-hole 311 may be formed on an upper portion of the first board 310, and a vertical length of the first through-hole 311 may be formed to be half or more of a vertical length of the first board 310.

The first through-hole 311 may be formed of a plurality of first through-holes 311. The plurality of first through-holes 311 may be formed one by one in the plurality of sections S1, S2, S3, and S4. That is, the plurality of first through-holes 311 may include a 1-1 through-hole 3111 formed in the first section S1, a 1-2 through-hole 3112 formed in the second section S2, a 1-3 through-hole 3113 formed in the third section S3, and a 1-4 through-hole 3114 formed in the fourth section S4.

The first board 310 and the second board 320 may be in surface contact with each other. That is, a front surface of the second board 320 may be disposed on a rear surface of the first board 310.

The second board 320 and the heat dissipating plate 330 may be installed to be in surface contact with each other. That is, a front surface of the heat dissipating plate 330 may be disposed on a rear surface of the second board 320.

Since the power element and the control element may be disposed on the front surface of the first board 310 and the rear surface of the first board 310 needs to be installed to be in surface contact with the front surface of the second board 320, the rear surface of the first board 310 may not be provided with any element.

In addition, since the RF elements may be disposed on the front surface of the second board 320 and the rear surface of the second board 320 needs to be installed to be in surface contact with the front surface of the heat dissipating plate 330, the rear surface of the second board 320 may not be provided with any element. In addition, since the rear surface of the first board 310 and the front surface of the second board 320 need to be installed to be in surface contact with each other, the RF elements disposed on the front surface of the second board 320 may pass through the first through-hole 311 formed in the first board 310.

A second through-hole 321 (see FIG. 6) may be formed in the second board 320 at a position corresponding to the first through-hole 311 to pass through the second board 320 in the front-rear direction. The second through-hole 321 may be formed to have a much smaller size than the first through-hole 311. The second through-hole 321 may be formed as a square hole large enough for a heating element 322 to be described below to pass therethrough.

The second through-hole 321 may be formed of a plurality of second through-holes 321. Each of the plurality of second through-holes 321 may be formed at a position corresponding to each of the plurality of first through-holes 311. That is, the plurality of second through-holes 321 may include a 2-1 through-hole 3211 formed at a position corresponding to the 1-1 through-hole 3111, a 2-2 through-hole 3212 formed at a position corresponding to the 1-2 through-hole 3112, a 2-3 through-hole 3213 formed at a position corresponding to the 1-3 through-hole 3113, and a 2-4 through-hole 3214 formed at a position corresponding to the 1-4 through-hole 3114.

The heating element 322 (see FIG. 6) may be mounted on the second board 320. The heating element 322 may pass through the first through-hole 311 formed in the first board 310 and the second through-hole 321 formed in the second board 320.

A thickness of the first board 310 and the second board 320 in contact with each other in the front-rear direction may be formed to be smaller than a thickness of the heating element 322 in the front-rear direction. Accordingly, when the first board 310, the second board 320, and the heat dissipating plate 330 are in a state of being coupled to one another, the front surface of the heating element 322 may be disposed on the same plane as the front surface of the first board 310, and a rear portion of the heating element 322 may be disposed to protrude from a rear portion of the second board 320.

The heating element 322 may be the RF element mounted on the second board 320. Among the RF elements, since the transmission amplification element Tx generates the most heat, the heating element 322 is preferably the transmission amplification element Tx. In addition, in order to dissipate the heat generated from the heating element 322 rearward, the heating element 322 is preferably mounted on the second board 320 behind the first board 310.

When the first board 310, the second board 320, and the heat dissipating plate 330 are in the state of being coupled to one another, the rear surface of the heating element 322 may be in contact with the front surface of the heat dissipating plate 330. Accordingly, the heat generated from the heating element 322 may be easily transmitted rearward through the heat dissipating plate 330.

In the embodiment, an insertion groove 331 (see FIG. 6) may be formed in the front surface of the heat dissipating plate 330. When the first board 310, the second board 320, and the heat dissipating plate 330 are in the state of being coupled to one another, a rear end of the heating element 322 may be inserted into the insertion groove 331.

The insertion groove 331 may be formed to have an open front at a position corresponding to the second through-hole 321. The insertion groove 331 may be formed to have the same size as the second through-hole 321. The insertion groove 331 may be formed to have the same size as the second through-hole 321, and in the embodiment, the insertion groove 331 may be formed in a square shape.

The insertion groove 331 may be formed of a plurality of insertion grooves 331. Each of the plurality of insertion grooves 331 may be formed at a position corresponding to each of the plurality of second through-holes 321. That is, the plurality of insertion grooves 331 may include a first insertion groove 3311 formed at a position corresponding to the 2-1 through-hole 3211, a second insertion groove 3312 formed at a position corresponding to the 2-2 through-hole 3212, a third insertion groove 3313 formed at a position corresponding to the 2-3 through-hole 3213, and a fourth insertion groove 3314 formed at a position corresponding to the 2-4 through-hole 3214.

The heating element 322 may be formed of a plurality of heating elements 322. Each of the plurality of heating elements 322 may pass through each of the plurality of first through-holes 311 and each of the plurality of second through-holes 321, and a rear end of each of the plurality of heating elements 322 may be in contact with the front surface of the heat dissipating plate 330. In the embodiment, since the plurality of insertion grooves 331 are formed in the front surface of the heat dissipating plate 330, the rear end of each of the plurality of heating elements 322 may be inserted into each of the plurality of insertion grooves 331. That is, the plurality of heating elements 322 may include a first heating element 3221 passing through the 1-1 through-hole 3111 and the 2-1 through-hole 3211 and having a rear end inserted into the first insertion groove 3311, a second heating element 3222 passing through the 1-2 through-hole 3112 and the 2-2 through-hole 3212 and having a rear end inserted into the second insertion groove 3312, a third heating element 3223 passing through the 1-3 through-hole 3113 and the 2-3 through-hole 3213 and having a rear end inserted into the third insertion groove 3313, and a fourth heating element 3224 passing through the 1-4 through-hole 3114 and the 2-4 through-hole 3214 and having a rear end inserted into the fourth insertion groove 3314.

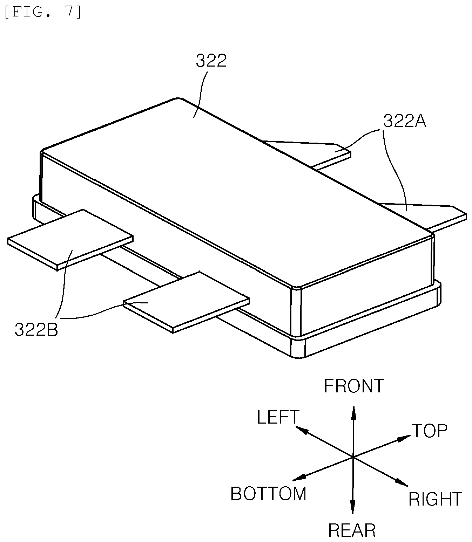

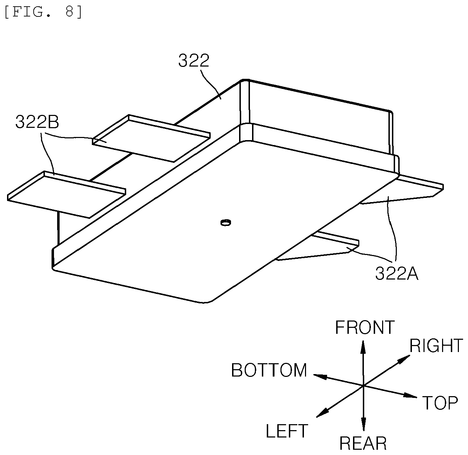

FIG. 7 is a perspective view showing the heating element shown in FIG. 5, and FIG. 8 is a perspective view of a bottom surface of the heating element in FIG. 7.

Referring to FIGS. 6 to 8, the heating element 322 may be formed approximately in a hexahedral shape. A rear edge of the heating element 322 may be formed to protrude outward compared to a front edge of the heating element 322, and the protruding portion may be inserted into the insertion groove 331.

In addition, the heating element 322 may be provided with terminals 322A and 322B electrically connected to a circuit printed on the front surface of the second board 320. The terminals 322A and 322B may be formed to protrude from the front edge of the heating element 322 in opposite directions.

The terminals 322A and 322B may be formed of a plurality of terminals 322A and 322B. The plurality of terminals 322A and 322B may include the first terminal 322A formed at an upper side of the heating element 322 and the second terminal 322B formed at a lower side of the heating element 322. The first terminal 322A may be formed of a pair of first terminals 322A, and the second terminal 322B may be formed of a pair of second terminals 322B.

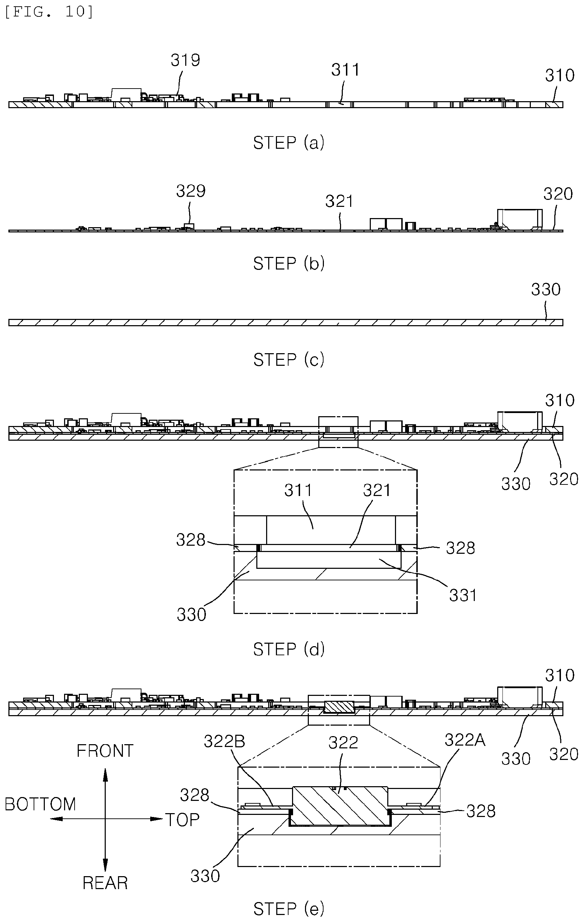

The terminals 322A and 322B of the heating element 322 may be soldered to a terminal mounting part 328 (see FIG. 10) of the circuit printed on the front surface of the second board 320 and electrically connected to the circuit printed on the front surface of the second board 320.

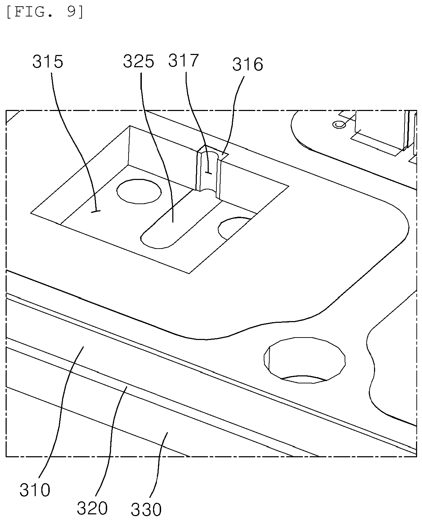

FIG. 9 is an enlarged view of portion A in FIG. 1.

Referring to FIGS. 1 and 9, a circuit connection part 316 may be formed on the first board 310. The circuit connection part 316 may extend from the front surface of the first board 310 to the rear surface of the first board 310 and may be electrically connected to a circuit 325 printed on the front surface of the second board 320.

A connector pin connection hole 317 extending in the front-rear direction may be formed in the circuit connection part 316. A connector pin formed on a rear surface of a filter may be inserted into the connector pin connection hole 317 and electrically connected to the circuit connection part 316. Since the connector pin of the filter is electrically connected to the circuit connection part 316, the filter may be electrically connected to the circuit printed on the front surface of the second board 320. Here, the filter may be a component for serving to filter an input RF signal and input an RF signal of a specific frequency band to the power amplification device 300.

Specifically, an opening hole 315 extending in the front-rear direction may be formed in the first board 310, the circuit connection part 316 may be provided on a side surface of the opening hole 315, and a portion of the connector pin connection hole 317, which faces the side surface of the opening hole 315 may be open.

FIG. 10 is a view showing one embodiment of a process of manufacturing the power amplification device shown in FIG. 1. Here, for understanding of description, an example in which one first through-hole 311, one second through-hole 321, one insertion groove 331, and one heating element 322 are only provided will be described.

Referring to FIG. 10, in the method of manufacturing the power amplification device 300 according to one embodiment of the present disclosure, the elements 319 and 329 may be respectively mounted on the first board 310 and the second board 320 and reflowed, and then the first board 310, the second board 320, and the heat dissipating plate 330 may be laminated and bonded by reflowing.

Specifically, the method of manufacturing the power amplification device 300 according to one embodiment of the present disclosure may include a step (a), a step (b), a step (c), a step (d), and a step (e).

In step (a), a solder cream may be applied to the front surface of the first board 310 in which the first through-hole 311 extending in the front-rear direction is formed, and then the rear surface of the first element 319 may be reflowed (meaning a process of performing soldering by applying heat to the solder cream) to the front surface of the first board 310. In this case, the first element 319 may be completely fixedly mounted on the front surface of the first board 310. Here, the first element 319 may be the power element and the control element mounted on the front surface of the first board 310. Then, in step (a), the solder cream may be applied to the rear surface of the first board 310. When the solder cream is applied to the rear surface of the first board 310, the first board 310 may be fixed to a jig so that the rear surface of the first board 310 faces upward, and then the solder cream may be applied to the rear surface of the first board 310. Here, the solder cream applied to the rear surface of the first board 310 may be applied to reflow the rear surface of the first board 310 to the front surface of the second board 320 in step (e).

In step (b), the solder cream may be applied to the front surface of the second board 320 in which the second through-hole 321 extending in the front-rear direction is formed at a position corresponding to the first through-hole 311, and then the rear surface of the second element 329 may be reflowed to the front surface of the second board 320. In this case, the second element 329 may be completely fixedly mounted on the front surface of the second board 320. Here, the second element 329 may be an element excluding the transmission amplification element Tx, which is the heating element 322, among the RF elements mounted on the front surface of the second board 320.

In step (c), the solder cream may be applied to the front surface of the heat dissipating plate 330. Here, the solder cream applied to the front surface of the heat dissipating plate 330 may be applied to reflow the rear surface of the second board 320 to the front surface of the heat dissipating plate 330 in step (e).

In step (d), the rear surface of the second board 320 may be disposed on the front surface of the heat dissipating plate 330, and the rear surface of the first board 310 may be disposed on the front surface of the second board 320. Accordingly, the second element 329 mounted on the second board 320 may pass through the first through-hole 311 formed in the first board 310. Since such a state is a state in which the rear surface of the first board 310 is not reflowed to the front surface of the second board 320 and the rear surface of the second board 320 is not reflowed to the front surface of the heat dissipating plate 330, the first board 310 and the second board 320 are not in a state of being completely coupled to each other, and the second board 320 and the heat dissipating plate 330 is not in a state of being completely coupled to each other. Then, in step (d), the solder cream may be applied to the terminal mounting part 328 of the circuit printed on the front surface of the second board 320. Here, the solder cream applied to the terminal mounting part 328 may be applied to reflow the terminals 322A and 322B of the heating element 322 to the terminal mounting part 328 in step (e). In addition, in step (d), the insertion groove 331 may be formed in the front surface of the heat dissipating plate 330 through the first through hole 311 and the second through hole 321.

In step (e), the heating element 322 may pass through the first through-hole 311 and the second through-hole 321 to bring the rear surface of the heating element 322 into contact with the front surface of the heat dissipating plate 330 and bring the terminals 322A and 322B of the heating element 322 into contact with the terminal mounting part 328, and then the rear surface of the second board 320 and the front surface of the heat dissipating plate 330, and the terminals 322A and 322B of the heating element 322 and the terminal mounting part 328 may be reflowed at the same time. Meanwhile, in the embodiment, since the insertion groove 331 is formed in the front surface of the heat dissipating plate 330 in step (d), the rear end of the heating element 322 may be inserted into the insertion groove 331 in step (e).

In the power amplification device 300 according to the embodiment shown in FIG. 10, since the first board 310 and the second board 320 are installed to be in surface contact with each other, the heat dissipating plate 330 is installed to be in surface contact with the second board 320, and the heating element 322 mounted on the second board 320 is in contact with the heat dissipating plate 330, the first board 310 and the second board 320 may be compactly formed, and the heat generated from the heating element 322 may be easily dissipated through the heat dissipating plate 330.

Meanwhile, in the above-described method of manufacturing the power amplification device 300 according to one embodiment of the present disclosure, since the reflow process, which is a process of performing soldering by applying heat to a solder cream, needs to be performed once in step (a), once in step (b), and once in step (e), there may be an inconvenience that the reflow process needs to be performed three times in total.

Hereinafter, one embodiment in which the reflow process is performed only once will be described with reference back to FIG. 10.

Referring to FIG. 10, in the method of manufacturing the power amplification device 300 according to one embodiment of the present disclosure, by laminating and bonding the first board 310, the second board 320, and the heat dissipating plate 330 in a state in which the elements 319 and 329 are only respectively mounted on the first board 310 and the second board 320 without reflowing, bonding the elements 319 and 329 to the boards 310 and 320, respectively, and bonding the boards 310 and 320 each other may be performed at once.

Specifically, in the method of manufacturing the power amplification device 300 according to one embodiment of the present disclosure, in step (a), the solder cream may be applied to the front surface of the first board 310 in which the first through-hole 311 extending in the front-rear direction is formed, and then the rear surface of the first element 319 may be mounted on the front surface of the first board 310. In this case, the first element 319 may be temporarily fixed to the front surface of the first board 310 by the viscosity of the solder cream applied to the front surface of the first board 310. Here, the solder cream applied to the front surface of the first board 310 may be applied to reflow the rear surface of the first element 319 to the front surface of the first board 310 in step (e). Then, in step (a), the solder cream may be applied to the rear surface of the first board 310. When the solder cream is applied to the rear surface of the first board 310, the first board 310 may be fixed to a jig so that the rear surface of the first board 310 faces upward, and then the solder cream may be applied to the rear surface of the first board 310. Here, the solder cream applied to the rear surface of the first board 310 may be applied to reflow the rear surface of the first board 310 to the front surface of the second board 320 in step (e).

In step (b), the solder cream may be applied to the front surface of the second board 320 in which the second through-hole 321 extending in the front-rear direction is formed at a position corresponding to the first through-hole 311, and then the rear surface of the second element 329 may be reflowed to the front surface of the second board 320. In this case, the second element 329 may be temporarily fixed to the front surface of the second board 320 by the viscosity of the solder cream applied to the front surface of the second board 320. Here, the solder cream applied to the front surface of the second board 320 may be applied to reflow the rear surface of the second element 329 to the front surface of the second board 320 in step (e).

In step (c), the solder cream may be applied to the front surface of the heat dissipating plate 330. Here, the solder cream applied to the front surface of the heat dissipating plate 330 may be applied to reflow the rear surface of the second board 320 to the front surface of the heat dissipating plate 330 in step (e).

In step (d), the rear surface of the second board 320 may be disposed on the front surface of the heat dissipating plate 330, and the rear surface of the first board 310 may be disposed on the front surface of the second board 320. Accordingly, the second element 329 mounted on the second board 320 may pass through the first through-hole 311 formed in the first board 310. Since such a state is a state in which the rear surface of the first board 310 is not reflowed to the front surface of the second board 320 and the rear surface of the second board 320 is not reflowed to the front surface of the heat dissipating plate 330, the first board 310 and the second board 320 are not in a state of being completely coupled to each other, and the second board 320 and the heat dissipating plate 330 is not in a state of being completely coupled to each other. Then, in step (d), the solder cream may be applied to the terminal mounting part 328 of the circuit printed on the front surface of the second board 320. Here, the solder cream applied to the terminal mounting part 328 may be applied to reflow the terminals 322A and 322B of the heating element 322 to the terminal mounting part 328 in step (e). In addition, in step (d), the insertion groove 331 may be formed in the front surface of the heat dissipating plate 330 through the first through hole 311 and the second through hole 321.

In step (e), after the heating element 322 may pass through the first through-hole 311 and the second through-hole 321 so that the rear surface of the heating element 322 is in contact with the front surface of the heat dissipating plate 330 and the terminals 322A and 322B are in contact with the terminal mounting part 328, the rear surface of the first element 319 and the front surface of the first board 310, the rear surface of the second element 329 and the front surface of the second board 320, the rear surface of the first board 310 and the front surface of the second board 320, the rear surface of the second board 320 and the front surface of the heat dissipating plate 330, and the terminals 322A and 322B of the heating element 322 and the terminal mounting part 328 may be reflowed at the same time. Meanwhile, in the embodiment, since the insertion groove 331 is formed in the front surface of the heat dissipating plate 330 in step (d), the rear end of the heating element 322 may be inserted into the insertion groove 331 in step (e).

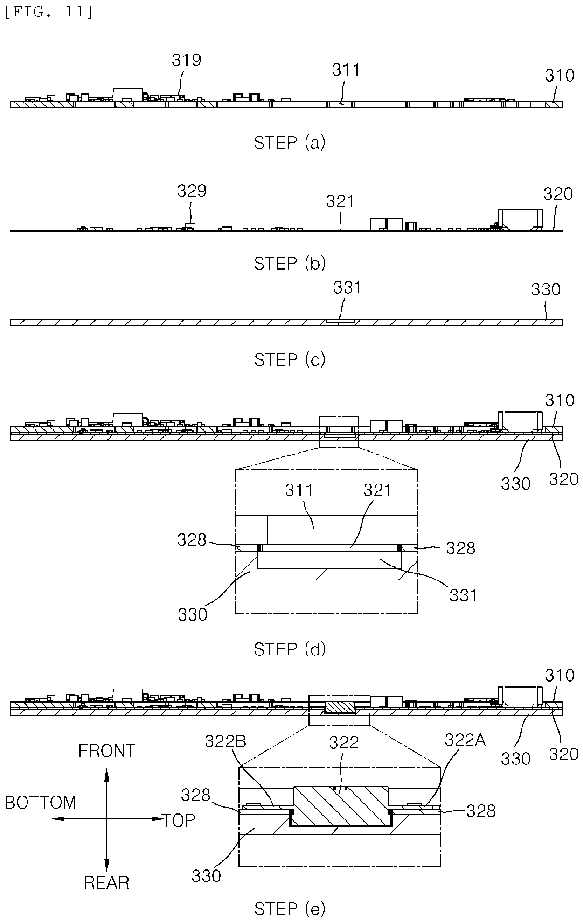

FIG. 11 is a view showing another embodiment of the process of manufacturing the power amplification device shown in FIG. 1. Here, for understanding of description, an example in which one first through-hole 311, one second through-hole 321, one insertion groove 331, and one heating element 322 are only provided will be described.

Referring to FIG. 11, it can be seen that the method of manufacturing the power amplification device 300 according to another embodiment of the present disclosure is different from the method of manufacturing the power amplification device 300 according to one embodiment of the present disclosure described with reference to FIG. 10.

That is, in one embodiment described with reference to FIG. 10, the insertion groove 331 is formed in the front surface of the heat dissipating plate 330 in step (d), but in another embodiment to be described with reference to FIG. 11, the insertion groove 331 may be previously formed in the front surface of the heat dissipating plate 330 before step (a). FIG. 11 shows that the insertion groove 331 is previously formed in the heat dissipating plate 330 shown in step (c).

Specifically, the method of manufacturing the power amplification device 300 according to another embodiment of the present disclosure may include a step (a), a step (b), a step (c), a step (d), and a step (e) .

In step (a), a solder cream may be applied to the front surface of the first board 310 in which the first through-hole 311 extending in the front-rear direction is formed, and then the rear surface of the first element 319 may be reflowed (meaning a process of performing soldering by applying heat to the solder cream) to the front surface of the first board 310. In this case, the first element 319 may be completely fixedly mounted on the front surface of the first board 310. Here, the first element 319 may be the power element and the control element mounted on the front surface of the first board 310. Then, in step (a), the solder cream may be applied to the rear surface of the first board 310. When the solder cream is applied to the rear surface of the first board 310, the first board 310 may be fixed to a jig so that the rear surface of the first board 310 faces upward, and then the solder cream may be applied to the rear surface of the first board 310. Here, the solder cream applied to the rear surface of the first board 310 may be applied to reflow the rear surface of the first board 310 to the front surface of the second board 320 in step (e).

In step (b), the solder cream may be applied to the front surface of the second board 320 in which the second through-hole 321 extending in the front-rear direction is formed at a position corresponding to the first through-hole 311, and then the rear surface of the second element 329 may be reflowed to the front surface of the second board 320. In this case, the second element 329 may be completely fixedly mounted on the front surface of the second board 320. Here, the second element 329 may be an element excluding the transmission amplification element Tx, which is the heating element 322, among the RF elements mounted on the front surface of the second board 320.

In step (c), the solder cream may be applied to the front surface of the heat dissipating plate 330. Here, the solder cream applied to the front surface of the heat dissipating plate 330 may be applied to reflow the rear surface of the second board 320 to the front surface of the heat dissipating plate 330 in step (e).

In step (d), the rear surface of the second board 320 may be disposed on the front surface of the heat dissipating plate 330, and the rear surface of the first board 310 may be disposed on the front surface of the second board 320. Accordingly, the second element 329 mounted on the second board 320 may pass through the first through-hole 311 formed in the first board 310. Since such a state is a state in which the rear surface of the first board 310 is not reflowed to the front surface of the second board 320 and the rear surface of the second board 320 is not reflowed to the front surface of the heat dissipating plate 330, the first board 310 and the second board 320 are not in a state of being completely coupled to each other, and the second board 320 and the heat dissipating plate 330 is not in a state of being completely coupled to each other. Then, in step (d), the solder cream may be applied to the terminal mounting part 328 of the circuit printed on the front surface of the second board 320. Here, the solder cream applied to the terminal mounting part 328 may be applied to reflow the terminals 322A and 322B of the heating element 322 to the terminal mounting part 328 in step (e).

In step (e), the heating element 322 may pass through the first through-hole 311 and the second through-hole 321 to bring the rear surface of the heating element 322 into contact with the front surface of the heat dissipating plate 330 and bring the terminals 322A and 322B of the heating element 322 into contact with the terminal mounting part 328, and then the rear surface of the second board 320 and the front surface of the heat dissipating plate 330, and the terminals 322A and 322B of the heating element 322 and the terminal mounting part 328 may be reflowed at the same time. Meanwhile, in the embodiment, since the insertion groove 331 is formed in the front surface of the heat dissipating plate 330 before step (a), the rear end of the heating element 322 may be inserted into the insertion groove 331 in step (e).

Meanwhile, in the above-described method of manufacturing the power amplification device 300 according to another embodiment of the present disclosure, since the reflow process, which is a process of performing soldering by applying heat to a solder cream, needs to be performed once in step (a), once in step (b), and once in step (e), there may be an inconvenience that the reflow process needs to be performed three times in total.

Hereinafter, another embodiment in which the reflow process is performed only once will be described with reference back to FIG. 11.

Specifically, in the method of manufacturing the power amplification device 300 according to another embodiment of the present disclosure, in the step (a), the solder cream may be applied to the front surface of the first board 310 in which the first through-hole 311 extending in the front-rear direction is formed, and then the rear surface of the first element 319 may be mounted on the front surface of the first board 310. In this case, the first element 319 may be temporarily fixed to the front surface of the first board 310 by the viscosity of the solder cream applied to the front surface of the first board 310. Here, the solder cream applied to the front surface of the first board 310 may be applied to reflow the rear surface of the first element 319 to the front surface of the first board 310 in step (e). Then, in step (a), the solder cream may be applied to the rear surface of the first board 310. When the solder cream is applied to the rear surface of the first board 310, the first board 310 may be fixed to a jig so that the rear surface of the first board 310 faces upward, and then the solder cream may be applied to the rear surface of the first board 310. Here, the solder cream applied to the rear surface of the first board 310 may be applied to reflow the rear surface of the first board 310 to the front surface of the second board 320 in step (e).

In step (b), the solder cream may be applied to the front surface of the second board 320 in which the second through-hole 321 extending in the front-rear direction is formed at a position corresponding to the first through-hole 311, and then the rear surface of the second element 329 may be reflowed to the front surface of the second board 320. In this case, the second element 329 may be temporarily fixed to the front surface of the second board 320 by the viscosity of the solder cream applied to the front surface of the second board 320. Here, the solder cream applied to the front surface of the second board 320 may be applied to reflow the rear surface of the second element 329 to the front surface of the second board 320 in step (e).

In step (c), the solder cream may be applied to the front surface of the heat dissipating plate 330. Here, the solder cream applied to the front surface of the heat dissipating plate 330 may be applied to reflow the rear surface of the second board 320 to the front surface of the heat dissipating plate 330 in step (e).

In step (d), the rear surface of the second board 320 may be disposed on the front surface of the heat dissipating plate 330, and the rear surface of the first board 310 may be disposed on the front surface of the second board 320. Accordingly, the second element 329 mounted on the second board 320 may pass through the first through-hole 311 formed in the first board 310. Since such a state is a state in which the rear surface of the first board 310 is not reflowed to the front surface of the second board 320 and the rear surface of the second board 320 is not reflowed to the front surface of the heat dissipating plate 330, the first board 310 and the second board 320 are not in a state of being completely coupled to each other, and the second board 320 and the heat dissipating plate 330 is not in a state of being completely coupled to each other. Then, in step (d), the solder cream may be applied to the terminal mounting part 328 of the circuit printed on the front surface of the second board 320. Here, the solder cream applied to the terminal mounting part 328 may be applied to reflow the terminals 322A and 322B of the heating element 322 to the terminal mounting part 328 in step (e).

In step (e), after the heating element 322 may pass through the first through-hole 311 and the second through-hole 321 so that the rear surface of the heating element 322 is in contact with the front surface of the heat dissipating plate 330 and the terminals 322A and 322B of the heating element 322 are in contact with the terminal mounting part 328, the rear surface of the first element 319 and the front surface of the first board 310, the rear surface of the second element 329 and the front surface of the second board 320, the rear surface of the first board 310 and the front surface of the second board 320, the rear surface of the second board 320 and the front surface of the heat dissipating plate 330, and the terminals 322A and 322B of the heating element 322 and the terminal mounting part 328 may be reflowed at the same time. Meanwhile, in the embodiment, since the insertion groove 331 is formed in the front surface of the heat dissipating plate 330 before step (a), the rear end of the heating element 322 may be inserted into the insertion groove 331 in step (e).

Meanwhile, referring to FIG. 10, in the power amplification device according to one embodiment of the present disclosure, the insertion groove 331 may be formed, and the first board 310 and the second board 320 in contact with each other in the front-rear direction may be formed to have a smaller thickness than the thickness of the heating element 322 in the front-rear direction. In this case, when the first board 310, the second board 320, and the heat dissipating plate 330 are in the state of being coupled to one another, since the rear portion of the heating element 322 is inserted into the insertion groove 331, the front surface of the heating element 322 may be disposed on the same plane as the front surface of the first board 310.

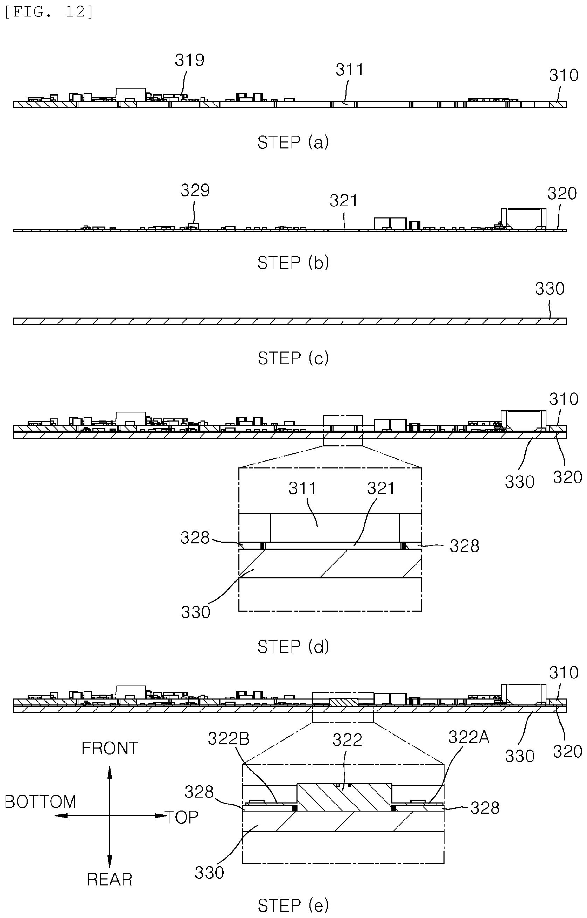

FIG. 12 is a view showing still another embodiment of the process of manufacturing the power amplification device shown in FIG. 1. Here, the same components in the embodiment described with reference to FIG. 10 are given the same reference numerals, and a detailed description thereof will be omitted, and only differences will be described.

Referring to FIG. 12, it can be seen that the power amplification device according to still another embodiment of the present disclosure is different from the above-described power amplification device of the embodiment shown in FIG. 10. That is, in the above-described power amplification device according to the embodiment shown in FIG. 10, the insertion groove 331 is formed in the front surface of the heat dissipating plate 330, but in the power amplification device according to the embodiment shown in FIG. 12, the insertion groove 331 is not formed in the heat dissipating plate 330. In the power amplification device according to the embodiment shown in FIG. 12, the thickness of the first board 310 and the second board 320 in contact with each other in the front-rear direction may be formed to be the same as the thickness of the heating element 322 in the front-rear direction. In this case, when the first board 310, the second board 320, and the heat dissipating plate 330 are in the state of being coupled to one another, since the rear surface of the heating element 322 may be in contact with an upper surface of the heat dissipating plate 330, and the front surface of the heating element 322 may be disposed on the same plane as the front surface of the first board 310.

Since the insertion groove 331 is not formed in the heat dissipating plate 330 in the power amplification device according to the embodiment shown in FIG. 12 compared to the power amplification device according to the embodiment shown in FIG. 10, it is possible to simplify the manufacturing process compared to the above-described power amplification device according to the embodiment shown in FIG. 10.

The front surface of the heating element 322 may be disposed on the same plane as the front surface of the first board 310 using one of the heat dissipating plate 330 in which the insertion groove 331 shown in FIG. 10 is formed and the heat dissipating plate 330 in which the insertion groove 331 shown in FIG. 12 is not formed according to the thickness of the first board 310 in the front-rear direction and the thickness of the second board 320 in the front-rear direction.

As described above, according to the power amplification device 300 and the method of manufacturing the same according to the embodiment of the present disclosure, since the first board 310 and the second board 320 are installed to be in surface contact with each other, the heat dissipating plate 330 is installed to be in surface contact with the second board 320, and the heating element 322 mounted on the second board 320 is in contact with the heat dissipating plate 330, the first board 310 and the second board 320 may be compactly formed, and the heat generated from the heating element 322 may be easily dissipated through the heat dissipating plate 330.

Those skilled in the art to which the present disclosure pertains will be able to understand that the present disclosure can be carried out in other specific forms without changing the technical spirit or essential features thereof. Accordingly, it should be understood that the above-described embodiments are illustrative and not restrictive in all respects. The scope of the present disclosure is defined by the appended claims rather than the detailed description, and all changes or modifications derived from the meaning and scope of the claims and equivalent concepts thereof should be construed as being included in the scope of the present disclosure.

### [Industrial Applicability]

The present disclosure provides a power amplification device and a method of manufacturing the same, which provide compact substrates by laminating a plurality of substrates, install a heat dissipating plate to be in surface contact with one of the plurality of substrates, and bring a heating element mounted on the substrate into contact with the heat dissipating plate, thereby improving heat dissipation performance.

## Claims

1. A power amplification device comprising:
a first board formed with a first through-hole passing through the first board in a front-rear direction;
a second board having a front surface disposed on a rear surface of the first board, formed with a second through-hole passing through the second board in the front-rear direction at a position corresponding to the first through-hole, and equipped with a heating element passing through the first through-hole and the second through-hole; and
a heat dissipating plate having a front surface disposed on a rear surface of the second board and a rear surface of the heating element in contact with a front surface thereof.

2. The power amplification device of claim 1, wherein an edge of each of the first board, the second board, and the heat dissipating plate is formed to have the same size.

3. The power amplification device of claim 1, wherein a terminal of the heating element is soldered to a terminal mounting part of a circuit printed to the front surface of the second board.

4. The power amplification device of claim 1, wherein a thickness of the second board in the front-rear direction is formed to be smaller than the thickness of the first board in the front-rear direction.

5. The power amplification device of claim 1, wherein a thickness of the first board and the second board in contact with each other in the front-rear direction is formed to be smaller than a thickness of the heating element in the front-rear direction.

6. The power amplification device of claim 1, wherein a thickness of the first board and the second board in contact with each other in the front-rear direction is formed to be the same as a thickness of the heating element in the front-rear direction.

7. The power amplification device of claim 1, wherein each of the first board and the second board is formed of a plurality of layers, and
the second board is formed of fewer layers than the first board.

8. The power amplification device of claim 1, wherein the first board is made of a synthetic resin material, and
the second board is made of a metal material.

9. The power amplification device of claim 1, wherein a vertical length of the first through-hole is formed to be half or more of a vertical length of the first board, and
the second through-hole is formed to have a smaller size than the first through-hole.

10. The power amplification device of claim 1, wherein a front surface of the heat dissipating plate is formed with an insertion groove into which a rear end of the heating element is inserted.

11. The power amplification device of claim 10, wherein the first board includes a plurality of sections divided by plated portions, which form a circuit printed on the front surface of the first board, in a left-right direction,
the first through-hole is formed one by one in the plurality of sections and formed of a plurality of first through-holes,
the second through-hole is formed at a position corresponding to each of the plurality of first through-holes and formed of a plurality of second through-holes,
the insertion groove is formed at a position corresponding to each of the plurality of second through-holes and formed of a plurality of insertion grooves, and
the heating element passes through each of the plurality of first through-holes and each of the plurality of second through-holes and formed of a plurality of heating elements, each of which has a rear end inserted into each of the plurality of insertion grooves.

12. The power amplification device of claim 1, wherein the heating element is formed as a radio frequency (RF) element.

13. The power amplification device of claim 12, wherein the heating element is formed as a transmission amplification element.

14. The power amplification device of claim 12, wherein the first board is equipped with a power element and a control element.

15. The power amplification device of claim 12, wherein the first board is formed with a circuit connection part extending from the front surface of the first board to the rear surface of the first board and electrically connected to a circuit printed on the front surface of the second board, and
the circuit connection part is formed with a connector pin connection hole, which has a connector pin formed on a rear surface of a filter inserted therein and is electrically connected to the circuit connection part, to extend in the front-rear direction.

16. The power amplification device of claim 15, wherein the first board is formed with an opening hole extending in the front-rear direction,
the circuit connection part is provided on a side surface of the opening hole, and
the connector pin connection hole has an open portion opposite to the side surface of the opening hole.

17. A method of manufacturing a power amplification device, comprising:
step (a) of applying a solder cream to a front surface of a first board formed with a first through-hole extending in a front-rear direction, then reflowing a rear surface of a first element to the front surface of the first board, and applying the solder cream to the rear surface of the first board;
step (b) of applying the solder cream to a front surface of a second board formed with a second through-hole extending in the front-rear direction at a position corresponding to the first through-hole and then reflowing a rear surface of a second element to the front surface of the second board;
step (c) of applying the solder cream to a front surface of a heat dissipating plate;
step (d) of arranging a rear surface of the second board on the front surface of the heat dissipating plate, arranging the rear surface of the first board on the front surface of the second board, and then applying the solder cream to a terminal mounting part of a circuit printed on the front surface of the second board; and
step (e) of passing the heating element through the first through-hole and the second through-hole to bring a rear surface of the heating element into contact with the front surface of the heat dissipating plate, bringing a terminal of the heating element into contact with the terminal mounting part, and then reflowing the rear surface of the first board and the front surface of the second board, the rear surface of the second board and the front surface of the heat dissipating plate, and the terminal of the heating element and the terminal mounting part at the same time.

18. The method of claim 17, wherein in step (d), the front surface of the heat dissipating plate is formed with an insertion groove through the first through-hole and the second through-hole, and
in step (e), a rear end of the heating element is inserted into the insertion groove.

19. The method of claim 17, wherein in step (e), a rear end of the heating element is inserted into an insertion groove formed in the front surface of the heat dissipating plate.

20. The method of claim 18 or 19, wherein the first board includes a plurality of sections divided by plated portions, which form a circuit printed on the front surface of the first board, in a left-right direction,
the first through-hole is formed one by one in the plurality of sections and formed of a plurality of first through-holes,
the second through-hole is formed at a position corresponding to each of the plurality of first through-holes and formed of a plurality of second through-holes,
the insertion groove is formed at a position corresponding to each of the plurality of second through-holes and formed of a plurality of insertion grooves, and
the heating element passes through each of the plurality of first through-holes and each of the plurality of second through-holes and formed of a plurality of heating elements, each of which has a rear end inserted into each of the plurality of insertion grooves.

21. A method of manufacturing a power amplification device, comprising:
step (a) of applying a solder cream to a front surface of a first board formed with a first through-hole extending in a front-rear direction, then mounting a rear surface of a first element to the front surface of the first board, and applying the solder cream to the rear surface of the first board;
step (b) of applying the solder cream to a front surface of a second board formed with a second through-hole extending in the front-rear direction at a position corresponding to the first through-hole and then mounting a rear surface of a second element to the front surface of the second board;
step (c) of applying the solder cream to a front surface of a heat dissipating plate;
step (d) of arranging a rear surface of the second board on the front surface of the heat dissipating plate, arranging the rear surface of the first board on the front surface of the second board, and then applying the solder cream to a terminal mounting part of a circuit printed on the front surface of the second board; and
step (e) of passing the heating element through the first through-hole and the second through-hole to bring a rear surface of the heating element into contact with the front surface of the heat dissipating plate, bringing a terminal of the heating element into contact with the terminal mounting part, and then reflowing the rear surface of the first element and the front surface of the first board, the rear surface of the second element and the front surface of the second board, the rear surface of the first board and the front surface of the second board, the rear surface of the second board and the front surface of the heat dissipating plate, and the terminal of the heating element and the terminal mounting part at the same time.

22. The method of claim 21, wherein in step (d), the front surface of the heat dissipating plate is formed with an insertion groove through the first through-hole and the second through-hole, and
in step (e), a rear end of the heating element is inserted into the insertion groove.

23. The method of claim 21, wherein in step (e), a rear end of the heating element is inserted into an insertion groove formed in the front surface of the heat dissipating plate

24. The method of claim 22 or 23, wherein the first board includes a plurality of sections divided by plated portions, which form a circuit printed on the front surface of the first board, in a left-right direction,
the first through-hole is formed one by one in the plurality of sections and formed of a plurality of first through-holes,
the second through-hole is formed at a position corresponding to each of the plurality of first through-holes and formed of a plurality of second through-holes,
the insertion groove is formed at a position corresponding to each of the plurality of second through-holes and formed of a plurality of insertion grooves, and
the heating element passes through each of the plurality of first through-holes and each of the plurality of second through-holes and formed of a plurality of heating elements, each of which has a rear end inserted into each of the plurality of insertion grooves.
